# EUROPEAN PATENT APPLICATION

(11) **EP 4 826 407 A1**
(43) Date of publication of application: **21.10.2026**
(21) Application number: 25171316.0
(22) Date of filing: 17.04.2025
(51) Int. Cl.: G01R 33/48, G01R 33/565, G06T 7/30, G01R 33/483, G01R 33/56

(54) **MOTION-COMPENSATED MULTI-SLAB 3D MRI**

(71) Applicant: Koninklijke Philips N.V., 5656 AE Eindhoven (NL)
(72) Inventor: MEINEKE, Jan Jakob, Eindhoven (NL); KEUPP, Jochen, Eindhoven (NL); SOMMER, Karsten, 5656AG Eindhoven (NL); LIPS, Oliver, Eindhoven (NL); DONEVA, Mariya Ivanova, Eindhoven (NL); BOERNERT, Peter Ulrich, Eindhoven (NL)
(74) Representative: Philips Intellectual Property & Standards

(57) **Abstract**

The invention relates to a method of magnetic resonance (MR) imaging, comprising: acquiring MR imaging data in two or more separate acquisition steps, each acquisition step covering a respective spatially distinct or partially overlapping sub-volume of a three dimensional volume of a subject; selecting or generating a reference image defining a target spatial coordinate system; and reconstructing at least one image representation of the sub-volumes using a motion- compensated reconstruction process comprising either one of: independently reconstructing respective image representations of the sub-volumes from the MR imaging data and transforming at least one of the reconstructed image representations based on the reference image such that all reconstructed image representations are geometrically consistent with the target spatial coordinate system; or jointly reconstructing a common image representation of the three-dimensional volume from the MR imaging data of all acquisition steps, wherein the reconstruction involves a geometric mapping to the reference image such that the common image representation is geometrically consistent with the target spatial coordinate system. Moreover, the invention relates to an MR imaging system configured to perform the method.

## Description

### FIELD OF THE INVENTION

The invention relates to the field of magnetic resonance (MR). It finds particular application in conjunction with MR imaging methods and MR scanners for diagnostic purposes, and will be described with particular reference thereto.

### BACKGROUND OF THE INVENTION

Image-forming MR methods that utilize the interaction between magnetic fields and nuclear spins in order to form two-dimensional or three-dimensional (3D) images are widely used nowadays, notably in the field of medical diagnostics, because for imaging of soft tissue they are superior to other imaging methods in many respects, do not require ionizing radiation and are usually not invasive.

In clinical practice, 3D imaging techniques are increasingly employed due to their ability to produce isotropic voxel data that can be reformatted in arbitrary orientations. However, the extended acquisition times required for 3D scans make them particularly susceptible to subject motion. Even small movements during scanning may introduce inconsistencies into the acquired k-space data, leading to image artifacts such as blurring or ghosting, and may limit diagnostic reliability.

Known retrospective motion-compensated reconstruction methods address this problem by estimating subject motion from the acquired data and incorporating this information into the reconstruction process. A widely used class of such techniques is iterative retrospective motion-compensated reconstruction. These methods typically divide the acquisition into motion segments and assume that the subject undergoes rigid-body transformations between segments. During each iteration, the algorithm altemates between updating the image based on current motion estimates and refining the motion estimates based on the current image. The motion for each segment is represented by a geometric transformation, usually involving rotations and translations, which is applied either in the image domain or incorporated into the forward signal model used during reconstruction.

While these methods are effective in reducing intra-scan motion artifacts, they introduce an intrinsic ambiguity in the final image coordinate system. Because only relative motion between segments is estimated, any global rigid-body transformation can be absorbed into the set of motion parameters without affecting the intemal consistency of the reconstructed image. As a result, the spatial orientation and position of the final image volume remains undefined up to a rigid transformation.

This limitation becomes particularly problematic in examinations involving multiple separate 3D scans. In many clinical applications, such as time-of-flight MR angiography or whole-brain anatomical imaging, the target volume is acquired in a series of spatially distinct sub-volumes using multiple scans, often referred to as a multi-slab protocol. In other applications, multiple 3D scans may be acquired with different contrast weightings, for example T₁-weighted, T₂-weighted, or proton-density-weighted sequences, in order to highlight different tissue characteristics. If motion occurs between or during these separate scans, and each scan is reconstructed independently using motion-compensated techniques, the resulting sub-volumes may reside in mutually inconsistent coordinate systems. This makes it difficult or impossible to combine, compare, or jointly process the resulting images.

The lack of a well-defined, common spatial reference frame across separately acquired sub-volumes complicates post-processing steps such as slab stitching, segmentation, or registration to anatomical templates. It may also negatively impact the visual assessment of anatomical continuity across scan boundaries and hinders the integration of automated analysis tools that depend on spatial consistency.

### SUMMARY OF THE INVENTION

From the foregoing it is readily appreciated that there is a need for a reconstruction framework that maintains the advantages of iterative retrospective motion-compensated MR imaging while also providing a mechanism to solve the described problem of geometric inconsistencies between image sub-volumes.

The invention discloses a method of MR imaging comprising the following steps:
a) acquiring MR imaging data in two or more separate acquisition steps, each acquisition step covering a respective spatially distinct or partially overlapping sub-volume of a three dimensional volume of a subject;
b) selecting or generating a reference image defining a target spatial coordinate system; and
c) reconstructing at least one image representation of the sub-volumes using a motion-compensated reconstruction process comprising either:
   - independently reconstructing respective image representations of the sub-volumes from the MR imaging data and transforming at least one of the reconstructed image representations based on the reference image such that all reconstructed image representations are geometrically consistent with the target spatial coordinate system; or
   - jointly reconstructing a common image representation of the three-dimensional volume from the MR imaging data of all acquisition steps, wherein the reconstruction involves a geometric mapping to the reference image such that the common image representation is geometrically consistent with the target spatial coordinate system.

The invention provides a method for motion-compensated reconstruction in which all reconstructed sub-volumes are aligned to a common spatial reference frame. According to the invention, MR imaging data are acquired in a plurality of separate acquisition steps (i.e. scans or scan sub-elements), each acquisition step covering a respective spatially distinct sub-volume of a three-dimensional volume of the subject to be examined (the patient).

A motion-compensated reconstruction process is applied to each scan, wherein, e.g., rigid-body motion parameters are estimated and used to correct for intra-scan motion. A reference image is selected or generated, defining a target spatial coordinate system. The reconstructed sub-volumes are then spatially transformed based on the reference image, such that all sub-volumes are geometrically consistent with the same spatial frame.

By anchoring the reconstructed image sub-volumes to a shared reference coordinate system, the invention ensures geometric consistency across separately acquired scans, even in the presence of subject motion. This enables accurate slab combination, contrast comparison, post-processing and quantitative analysis, and improves the overall robustness and diagnostic utility of 3D MR imaging examinations involving multi-slab or multi-contrast protocols.

Alternatively, a common image representation of the three-dimensional volume is jointly reconstructed from the MR imaging data of all acquisition steps, wherein the reconstruction involves a geometric mapping to the reference image such that the common image representation is geometrically consistent with the target spatial coordinate system. In this variant, the reconstruction is not performed independently for each sub-volume. Instead, a common image representing the full spatial extent of the full three-dimensional volume is reconstructed, wherein the MR imaging data from all acquisition steps are incorporated into a single reconstruction process involving geometric mapping to the reference image to account for the geometric relationships between the acquired sub-volumes. This variant inherently ensures geometric consistency across all sub-volumes, as the reconstruction is performed directly in the target spatial coordinate system defined by the reference image, and it eliminates the need for subsequent alignment or stitching of independently reconstructed volumes.

According to an embodiment, the motion-compensated reconstruction process comprises a retrospective iterative motion compensation method. In such methods, the reconstruction alternates between image estimation and motion estimation, refining both until convergence. Each acquisition is segmented into temporal intervals for which rigid-body motion is estimated. These estimates are incorporated into the reconstruction process to correct the data and reduce motion-induced artifacts. Retrospective iterative motion compensation is advantageous because it operates without the need for external motion-tracking hardware and provides improved image quality in long 3D scans affected by motion.

In another embodiment, the reference image used to define the target spatial coordinate system is obtained from a separate acquisition/scan during the same MR imaging examination. This scan may serve as an anatomical reference or provide low-resolution spatial information. By sourcing the reference image from the same session, the method ensures anatomical relevance and compatibility in terms of patient position and scan geometry.

In a specific implementation of this concept, the reference image is an image acquired as part of a separate calibration scan. For example, the reference image can be a sensitivity calibration image, such as an image acquired in a SENSE reference scan. These scans are typically acquired in most modern MR imaging protocols for coil sensitivity mapping B₀ mapping etc. and cover the entire volume of interest with uniform contrast. They are acquired quickly and at low resolution, making them well suited as geometric anchors for aligning motion-corrected images from separate acquisitions. Leveraging a SENSE reference scan as a common reference ensures minimal overhead and broad applicability in clinical settings.

In another embodiment, the reference image is not acquired separately but instead generated by registering overlapping spatial regions of the reconstructed sub-volumes. When the sub-volumes exhibit overlap, registration techniques can be applied to extract a composite reference geometry. This approach avoids the need for additional scanning and enables purely data-driven spatial alignment across the sub-volumes.

Accordingly, selecting or generating a reference image defining a target spatial coordinate system may be performed upon manual instruction of a user of the system through a peripheral device, automatically based on criteria associated with specific clinical applications (i.e. some clinical applications require more stringent constraints than others), or a combination of manual instruction of the user and automatic clinical application-based criteria.

The transformation of the reconstructed image representations into the reference frame is preferably implemented as a rigid-body transformation determined by image registration. In this context, a rigid-body transformation includes three rotational and three translational degrees of freedom. Such transformations are well suited to correcting head or body movement during MR imaging scans without introducing geometric distortion, and they preserve anatomical structures.

The image registration process used to determine the rigid transformation may involve minimization of a similarity metric selected from mutual information, normalized gradient fields, mean squared error, mean absolute error etc. These metrics capture similarity between images with different contrasts or signal intensities. Mutual information and normalized gradient fields are particularly useful for multi-modal image registration, as they are contrast-insensitive. This allows the method to align images from different contrasts or reconstruction conditions robustly.

In a further embodiment, the MR imaging data of the separate acquisition steps are acquired with different image contrasts. This corresponds to clinical protocols involving multi-contrast imaging such as T₁-, T₂-, or proton-density-weighted scans. The ability to align and geometrically harmonize images with different contrasts is essential for enabling direct comparison and joint processing of complementary diagnostic information.

To further enhance registration accuracy in the multi-contrast scenario, the method may include a quantitative pre-scan to determine tissue parameters such as T₁, T₂, or proton density. Based on these parameters, the reference image is synthesized to match the contrast of the reconstructed sub-volume to be aligned. This enables contrast-specific alignment using synthetic reference images, improving robustness and accuracy in contrast-harmonized registration.

In another embodiment, the reference image or the reconstructed image representations of the sub-volumes are processed using a machine learning model trained to convert between different image contrasts. Such models, typically implemented as neural networks, can transform an image with one contrast weighting into a synthetic image with another contrast weighting, thereby facilitating multi-contrast registration. This enables the use of advanced data-driven contrast harmonization techniques, further improving alignment between anatomically equivalent structures across scans.

In yet another embodiment, the reconstructed image representations are transformed into a coordinate system aligned with a digital anatomical model or virtual human reference ("digital twin"). This provides a standardized spatial context for all reconstructed volumes, allowing for consistent, standardized viewing, interpretation, and integration into population-based analyses or atlas-based workflows. Registration to a digital twin also supports longitudinal studies and cross-patient comparisons.

In possible embodiments, the transformation applied to the reconstructed image representations to ensure geometric consistency with the reference image or with the digital anatomical mode may be implemented as a rigid-body transformation or, in alternative embodiments, as a non-rigid (deformable) transformation. While rigid-body transformations, involving only global translations and rotations, are sufficient in many cases, particularly for head imaging or in scenarios with limited motion, non-rigid transformations are advantageous in contexts where local spatial distortions must also be accounted for. In particular, deformable registration techniques may be employed to address differences in geometric distortion arising from the use of different sequence types across acquisition steps. For instance, scans acquired using spin-echo and gradient-echo sequences may exhibit different spatial distortions due to susceptibility-induced off-resonance effects, especially in regions near air-tissue interfaces or metallic implants. In such cases, a non-rigid transformation enables local correction of spatial mismatches between the reconstructed sub-volumes, thereby improving alignment accuracy and structural continuity. Suitable non-rigid registration methods include, for example, spline-based free-form deformation models or diffeomorphic transformations, which can provide smooth and topology-preserving mappings between images with varying distortion profiles.

To improve the visual continuity and structural consistency across the boundaries of the sub-volumes, the transformation step may include regularization based on minimizing intensity or image gradient discontinuities in boundary regions between sub-volumes. This ensures a smooth transition between adjacent sub-volumes and avoids abrupt visual discontinuities that may impair diagnostic readability, especially for anatomical structures such as vessels, which span multiple sub-volumes.

In yet a further embodiment, the transformation into the reference coordinate system is performed at a spatial resolution different from that of the image representations of the sub-volumes. For example, registration may be initially performed at lower resolution to improve robustness and computational efficiency, and the result may then be refined at higher resolution. This multi-scale strategy balances accuracy with processing time and is particularly effective in iterative reconstruction frameworks.

The method of the invention can be advantageously carried out in most MR environments in clinical use at present. To this end it is merely necessary to utilize a computer program by which the computer to be used is controlled such that it performs the above-explained method steps of the invention. The computer program may be present either on a data carrier or be present in a data network so as to be downloaded for installation in the computer, e.g., the control computer of an MR scanner.

### BRIEF DESCRIPTION OF THE DRAWINGS

The enclosed drawings disclose preferred embodiments of the present invention. It should be understood, however, that the drawings are designed for the purpose of illustration only and not as a definition of the limits of the invention. In the drawings:
Fig. 1 shows an MR imaging system for carrying out the method of the invention;
Fig. 2 illustrates an embodiment of the method of the invention as a flow chart;
Fig. 3 schematically illustrates the alignment of distinct motion-corrected sub-volumes in a common reference frame.

### DETAILED DESCRIPTION OF THE EMBODIMENTS

For the purposes of promoting and understanding the principles of the present disclosure, reference will now be made to the embodiments illustrated in the drawings, and specific language will be used to describe the same. It is nevertheless understood that no limitation to the scope of the disclosure is intended. Any alterations and further modifications to the described devices, systems, and methods, and any further application of the principles of the present disclosure are fully contemplated and included within the present disclosure as would normally occur to one skilled in the art to which the disclosure relates. In particular, it is fully contemplated that the features, components, and/or steps described with respect to one embodiment may be combined with the features, components, and/or steps described with respect to other embodiments of the present disclosure. For the sake of brevity, however, the numerous iterations of these combinations will not be described separately. Features described in relation to a system, may be implemented in a computer implemented method and/or in a computer program product, in a corresponding manner.

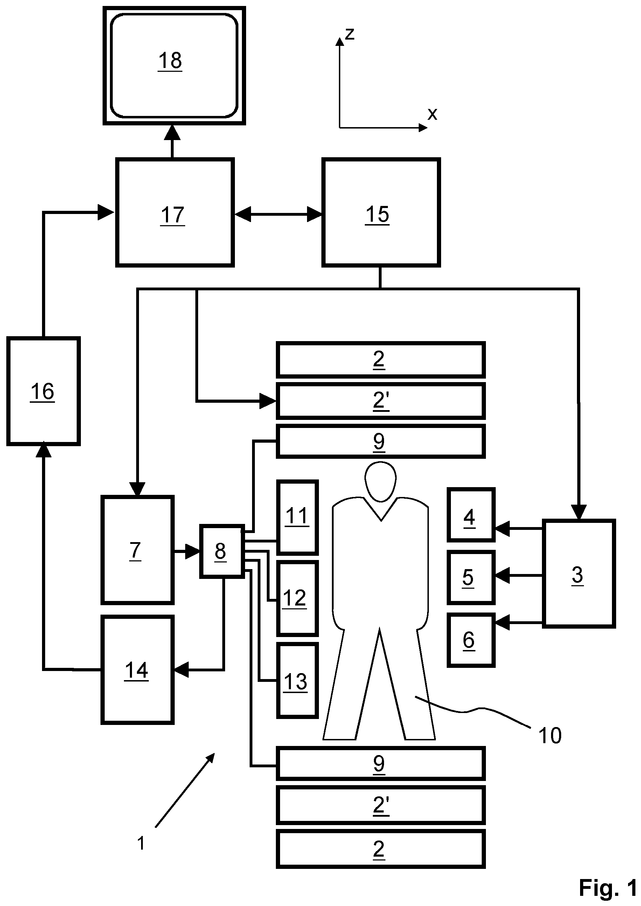

With reference to Fig. 1, an MR imaging system 1 is shown. The MR imaging system 1 includes an MR scanner comprising superconducting or resistive main magnet coils 2 such that a substantially uniform, temporally constant main magnetic field B₀ is created along a z-axis through an examination volume. The scanner further comprises a set of (1^{st}, 2^{nd}, and - where applicable - 3^{rd} order) shimming coils 2', wherein the current flow through the individual shimming coils of the set 2' is controllable for the purpose of minimizing B₀ deviations within the examination volume.

A magnetic resonance generation and manipulation system applies a series of radiofrequency (RF) pulses and switched magnetic field gradients to invert or excite nuclear magnetic spins, induce magnetic resonance, refocus magnetic resonance, manipulate magnetic resonance, spatially and otherwise encode the magnetic resonance, saturate spins, and the like to perform MR imaging.

More specifically, a gradient pulse amplifier 3 applies current pulses to selected ones of whole-body gradient coils 4, 5 and 6 along x, y and z-axes of the examination volume. A digital RF frequency transmitter 7 transmits RF pulses or pulse packets, via a send-/receive switch 8, to a body RF coil 9 to transmit RF pulses into the examination volume. A typical MR pulse sequence is composed of a packet of RF pulse segments of short duration which taken together with each other and any applied magnetic field gradients achieve a selected manipulation of nuclear magnetic resonance.

Any of the MR imaging sequences according to the invention, as well as other MR imaging sequences known in the art or protocols may be stored in a memory. The memory is intended to represent any combination of memory or storage device which is accessible to a computational system and/or processor comprised therein, configured to control the MR acquisition and/or reconstruction. The memory may include volatile and non-volatile memory storage means and components. The memory in some embodiments may be based on or may rely on cloud-based data stored in logical pools across disparate, commodity storage servers located on premises or in a data center managed by a third-party cloud provider.

The RF pulses are used to saturate, excite resonance, invert magnetization, refocus resonance, or manipulate resonance and select a portion of a body 10 positioned in the examination volume. The MR signals are also picked up by the body RF coil 9.

For generation of MR images of limited regions of the body 10 by means of parallel imaging, a set of local array RF coils 11, 12, 13 are placed contiguous to the region selected for imaging. The array coils 11, 12, 13 can be used to receive MR signals induced by body-coil RF transmissions.

The resultant MR signals are picked up by the body RF coil 9 and/or by the array RF coils 11, 12, 13 and demodulated by a receiver 14 preferably including a preamplifier (not shown). The receiver 14 is connected to the RF coils 9, 11, 12 and 13 via send-/receive switch 8.

A control computer 15 constitutes a processing unit controlling the current flow through the shimming coils 2' as well as the gradient pulse amplifier 3 and the transmitter 7 to generate any of a plurality of MR pulse sequences, such as echo planar imaging (EPI), echo volume imaging, gradient and spin echo imaging, fast spin echo imaging, and the like in conformity with a pre-determined examination protocol. For the respective examination protocol, the receiver 14 receives a single or a plurality of MR data lines in rapid succession following each RF excitation pulse. The functionality of the control computer may be provided by one or more control processors.

A data acquisition system 16 performs analog-to-digital conversion of the received signals and converts each MR data line to a digital format suitable for further processing. In modem MR scanners the data acquisition system 16 is a separate computer, which is specialized in acquisition of raw image data. The examination protocol determines the imaging sequences, i.e. the MR pulse sequences including the frequency and the temporal succession of radiofrequency pulses and/or magnetic field gradients to be activated. The parameters included in the examination protocol thereby characterize the MR image to be acquired, in particular with regard to location, orientation and size of the field of view as well as the contrast-weighting. The functionality of the data acquisition system may be provided by one or more data acquisition processors.

The digital raw image data is reconstructed into an image representation by a reconstruction unit 17 which applies a Fourier transform or other appropriate reconstruction algorithms, such like SENSE or SMASH. The functionality of the reconstruction unit may be provided by one or more reconstruction processors. The MR image represents a three-dimensional volume within the body 10. The image is then stored in a memory where it may be accessed for converting slices, projections, or other portions of the image representation into appropriate format for visualization, for example via a display screen 18, which provides a man-readable display of the resultant MR image. The display screen 18 may be integrated in the MR imaging system and/or may be a separate display device such a display screen, a tablet, smartphone, etc.

In some embodiments the functionalities of the control computer 15, the data acquisition system 16 and the reconstruction unit 17 are implemented in one computer system or their functionalities are provided by a processor or a network of processors.

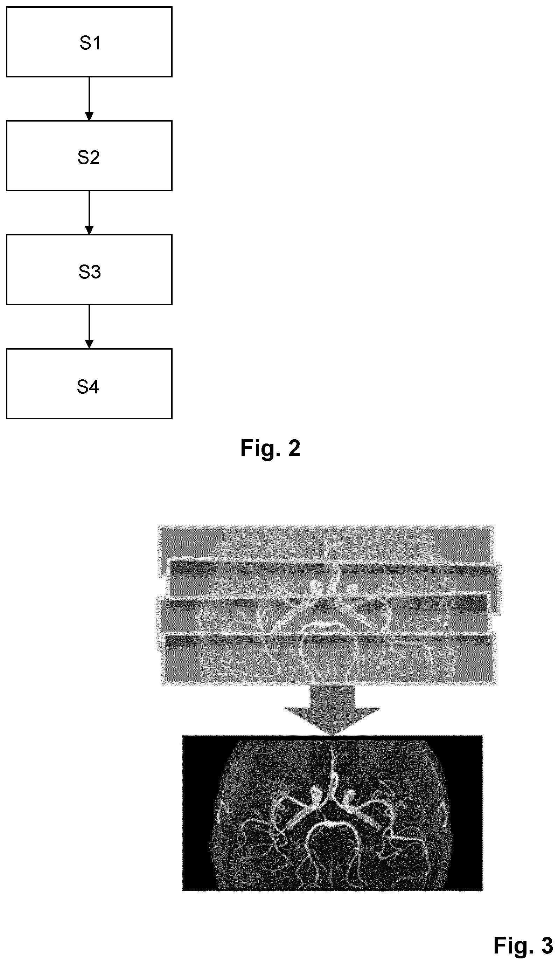

Referring now to Fig. 2, the method begins with the acquisition of MR imaging data in a plurality of separate acquisition steps (step S1), each covering a spatially distinct sub-volume of a three-dimensional target volume of the subject. In this embodiment, the data acquisition is performed as a multi-slab protocol, whereby multiple thin 3D slabs are acquired sequentially. The slabs may, for example, correspond to overlapping or adjacent regions in a head or vascular scan, such as in time-of-flight MR angiography.

During each acquisition step, subject motion may occur, both within individual slabs and between the separate slab acquisitions. In order to reduce intra-scan motion artifacts, each slab is reconstructed independently using a motion-compensated reconstruction process (step S2). Preferably, a retrospective iterative motion compensation method is employed, in which the slab-specific raw data are divided into motion segments. Rigid-body motion parameters are estimated for each segment and incorporated into the reconstruction through iterative alternating updates of image and motion estimates, as previously described.

Once motion-compensated reconstructions of the individual slabs have been obtained, a spatial reference image is selected or generated (step S3). In this embodiment, the reference image may be obtained from a separate calibration scan (e.g., a SENSE reference scan) acquired in the same examination session. Alternatively, the reference image may be computed by registering overlapping regions of the reconstructed slabs to one another, thereby deriving a composite target geometry.

In the next step (step S4), the reconstructed slab images are individually registered to the reference image and transformed accordingly, such that all slab images are brought into alignment with a common target spatial coordinate system. The registration may involve rigid-body transformations estimated by minimizing a similarity measure such as mutual information or normalized gradient fields, depending on the image contrasts.

Fig. 3 illustrates this process schematically. The top part of the figure shows the reconstructed slab images resulting from independent motion-compensated reconstruction, prior to spatial alignment. As shown, each slab appears geometrically displaced or rotated relative to its neighbors, due to motion differences between the acquisition steps. The slabs are thus disordered with respect to their true anatomical relationships, making it difficult to interpret or combine them.

The bottom part of Fig. 3 shows the slabs after transformation into the target spatial coordinate system in accordance with the invention. Each slab is now properly aligned with its neighbors, and their relative anatomical positioning is restored. The individual slabs are geometrically consistent with each other, enabling seamless combination into a single coherent 3D volume. This alignment facilitates further processing, such as visualization, segmentation, or diagnostic review, and is especially important in vascular or neuroimaging applications where anatomical continuity is critical.

It is understood that one or more of the aforementioned embodiments of the invention may be combined as long as the combined embodiments are not mutually exclusive.

In summary, the described embodiments demonstrate how the method of the invention effectively resolves the problem of coordinate inconsistency between motion-compensated image sub-volumes acquired in separate scans. By anchoring all reconstructions to a common reference frame, the method ensures spatial coherence of the resulting images and enables reliable diagnostic interpretation and post-processing.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as "system." Furthermore, aspects of the present invention may take the form of a computer program product embodied in one or more computer readable medium(s) having computer executable code embodied thereon, which computer executable code when executed by a computational system, causes the computational system to control a magnetic resonance imaging system and to perform any of the method embodiments of the invention.

## Claims

1. A method of magnetic resonance, MR, imaging, comprising:
acquiring MR imaging data in two or more separate acquisition steps, each acquisition step covering a respective spatially distinct or partially overlapping sub-volume of a three dimensional volume of a subject;
selecting or generating a reference image defining a target spatial coordinate system; and
reconstructing at least one image representation of the sub-volumes using a motion-compensated reconstruction process comprising either one of:
independently reconstructing respective image representations of the sub-volumes from the MR imaging data and transforming at least one of the reconstructed image representations based on the reference image such that all reconstructed image representations are geometrically consistent with the target spatial coordinate system;
jointly reconstructing a common image representation of the three-dimensional volume from the MR imaging data of all acquisition steps, wherein the reconstruction involves a geometric mapping to the reference image such that the common image representation is geometrically consistent with the target spatial coordinate system.

2. Method of claim 1, wherein the motion-compensated reconstruction process comprises a retrospective iterative motion compensation method.

3. Method of claim 1 or 2, wherein the reference image is obtained from a separate acquisition during the same MR imaging examination.

4. Method of any one of claims 1 to 3, wherein the reference image is an image acquired as part of a separate calibration scan.

5. Method of any one of claims 1 to 4, wherein the reference image is generated by registering overlapping spatial regions of the image representations of the sub-volumes.

6. Method of any one of claims 1 to 5, wherein the transformation is a rigid-body transformation determined by registration of the at least one of the reconstructed image representations of the sub-volumes with the reference image, wherein optionally, the image registration minimizes a similarity metric selected from mutual information, normalized gradient fields, mean squared error, or mean absolute error.

7. Method of any one of claims 1 to 6, wherein the MR imaging data of the separate acquisition steps are acquired with different image contrasts.

8. Method of claim 7, wherein the method further comprises a quantitative pre-scan to determine tissue parameters, wherein the reference image is synthesized according to the contrast of the reconstructed image representation of the respective sub-volume based on the determined tissue parameters.

9. Method of any one of claims 1 to 8, wherein the reference image or the reconstructed image representations of the sub-volumes are processed using a machine learning model trained to convert between different image contrasts.

10. Method of any one of claims 1 to 9, wherein the reconstructed image representations of the sub-volumes are transformed into a coordinate system aligned with a digital anatomical model or virtual human reference.

11. Method of any one of claims 1 to 10, wherein the transformation includes regularization based on minimizing intensity or image gradient discontinuities in boundary regions between the sub-volumes.

12. Method of claim 1 to 11, wherein the transformation is a rigid-body transformation or a non-rigid transformation.

13. Method of any one of claims 1 to 12, wherein the transformation is performed at a spatial resolution different from that of the image representations of the sub-volumes.

14. A magnetic resonance, MR, imaging system comprising:
an MR scanner (1) configured to acquire MR imaging data from a subject (10);
a processor (15, 16, 17) operatively connected to the MR scanner (1) and configured to:
acquire MR imaging data in two or more separate acquisition steps, each acquisition step covering a respective spatially distinct or partially overlapping sub-volume of a three dimensional volume of a subject;
select or generate a reference image defining a target spatial coordinate system; and
reconstruct at least one image representation of the sub-volumes using a motion-compensated reconstruction process comprising either:
independently reconstructing respective image representations of the sub-volumes from the MR imaging data and transforming at least one of the reconstructed image representations based on the reference image such that all reconstructed image representations are geometrically consistent with the target spatial coordinate system; or
jointly reconstructing a common image representation of the three-dimensional volume from the MR imaging data of all acquisition steps, wherein the reconstruction involves a geometric mapping to the reference image such that the common image representation is geometrically consistent with the target spatial coordinate system.

15. A computer program comprising instructions which, when executed by a processor, cause the processor to perform:
receiving magnetic resonance, MR, imaging data of two or more separate acquisition steps into a memory accessibly by the processor, each acquisition step covering a respective spatially distinct or partially overlapping sub-volume of a three-dimensional volume of a subject;
selecting or generating a reference image defining a target spatial coordinate system; and
reconstructing at least one image representation of the sub-volumes using a motion-compensated reconstruction process comprising either one of:
independently reconstructing respective image representations of the sub-volumes from the MR imaging data and transforming at least one of the reconstructed image representations based on the reference image such that all reconstructed image representations are geometrically consistent with the target spatial coordinate system;
jointly reconstructing a common image representation of the three-dimensional volume from the MR imaging data of all acquisition steps, wherein the reconstruction involves a geometric mapping to the reference image such that the common image representation is geometrically consistent with the target spatial coordinate system.
